# EUROPÄISCHE PATENTANMELDUNG

(11) **EP 0 967 488 A2**
(43) Veröffentlichungstag der Anmeldung: **29.12.1999**
(21) Anmeldenummer: 99110835.8
(22) Anmeldetag: 05.06.1999
(51) Int. Cl.: G01R 33/035, G01R 33/07

(54) **Magnetometer**

(30) Priorität: 24.06.1998 DE 19828089
(71) Anmelder: INSTITUT FÜR LUFT- UND KÄLTETECHNIK GEMEINNÜTZIGE GESELLSCHAFT mbH, 01309 Dresden (DE)
(72) Erfinder: Kaiser, Gunter, Dr. rer. nat., 01219 Dresden (DE); Seidel, Paul, Prof. Dr., 07745 Jena (DE); Schneidewind, Henrik, Dr., 07749 Jena (DE); Linzen, Sven, 07747 Jena (DE)
(74) Vertreter: Seefeld, Gerd

(57) **Zusammenfassung**

Mit der Erfindung soll ein supraleitendes Magnetometer vorgeschlagen werden, das in HTSL-Technologie mit einer sehr hohen Zuverlässigkeit und Reproduzierbarkeit realisiert werden kann und das Parameter erreicht, die mit denen von SQUID-Magnetometern vergleichbar sind.

Erfindungsgemäß wird ein Hall-Detektor 4 mit einem supraleitenden Magnetfeldverstärker mit einer Ringstruktur 3, die nahe am Hall-Detektor 4 zu einer Einkoppelleitung 5 verengt ist, kombiniert.

## Beschreibung

Neben Bolometern stellen Magnetometer eine wichtige Sensorik-Anwendung der Supraleiter-Hochtechnologie dar. Supraleitende Magnetometer werden nach dem gegenwärtigen Stand der Technik nur in Form von SQUID-Magnetometern eingesetzt. Als Detektor dient ein sogenanntes supraleitendes Quanteninterferenzdetektor (SQUID) in dem der Josephson-Effekt zur Umwandlung des eingekoppelten magnetischen Flusses in eine elektrische Spannung genutzt wird. Derartige miniaturisierte SQUID-Magnetometer erreichen eine außerordentliche hohe Empfindlichkeit und Auflösung, welche sonst nur noch von einigen wesentlich größeren Suchspulen-Magnetometern erreicht werden kann und in der Größenordnung bis 1 fT/√tHz liegen kann. Diese extrem hohe Empfindlichkeit wird durch die Kombination eines hocheffizienten supraleitenden Feld/Fluß-Wandlers (Flußtransformator) und des extrem flußempfindlichen SQUID-Detektor erreicht. SQUID-Magnetometer aus konventionellen Supraleiterwerkstoffen wie Niob oder Blei sind weit entwickelt und werden in Meßsystemen eingesetzt.

SQUID-Magnetometer aus Hochtemperatursupraleitern (HTSL) zeigen nur in Einzelfällen Parameter, welche mit den Parametern konventioneller SQUID-Magnetometer vergleichbar sind. Dies liegt jedoch hauptsächlich nicht an der höheren Arbeitstemperatur als vielmehr daran, daß sich die zur Erzeugung des Josephson-Effekts erforderlichen schwach supraleitenden Kontakte nicht mit den von konventionellen SQUIDs bekannten Eigenschaften herstellen lassen und oft nicht langzeitstabil sind. Dies kann als einer der Hauptgründe angesehen werden, weshalb sich HTSL-SQUID-Magnetometer bisher nicht durchsetzen konnten. Die supraleitenden Feld/Fluß-Wandler funktionieren dagegen außerordentlich zuverlässig und reproduzierbar, da die Herstellung und Strukturierung von HTSL-Dünnfilmen heute als ausgereift gelten kann und z.T. auch schon kommerzialisiert worden ist.

Aufgabe der Erfindung ist es, ein supraleitendes Magnetometer zu schaffen, welches auch in HTSL-Technologie mit einer sehr hohen Zuverlässigkeit und Reproduzierbarkeit realisiert werden kann und welches Parameter erreicht, die mit denen von SQUID-Magnetometern vergleichbar sind.

Diese Aufgabe wird durch die Merkmale des Patentanspruches gelöst, indem der Feld/Fluß-Wandler eines SQUID-Magnetometers durch einen hocheffizienten supraleitenden Feld/Feld-Wandler (Feldverstärker) und das SQUID durch einen der klassischen hochentwickelten und zuverlässigen Magnetfelddetektoren substituiert wird. Das Empfindlichkeitsdefizit des klassischen Detektors gegenüber einem SQUID wird dabei durch das Design des Feldverstärkers kompensiert. Als Detektor wird ein Hall-Element eingesetzt, da dieses im Vergleich zu anderen Detektoren, z.B. magnetoresistiven Elementen, nur geringe magnetische Rückwirkungen auf den Feldverstärker hat.

Befindet sich der Magnetfeldverstärker im supraleitenden Zustand, so wird unter der Einwirkung eines äußeren Magnetfelds ein magnetischer Fluß abgeschirmt, der sich multiplikativ aus der magnetischen Induktion des äußeren Feldes und der Fläche des Magnetfeldverstärkers ergibt Dabei wird in der Induktivität des Magnetfeldverstärkers ein Abschirmstrom erzeugt, der proportional zum Fluß und umgekehrt proportional zur Induktivität ist. Dieser fließt durch die Einkoppelleitung in deren Nahfeld sich der Hall-Detektor befindet. Durch die hohe Stromdichte in der Einkoppelleitung kann in deren Nahfeld eine wesentlich größere Induktion als die des anliegenden äußeren Magnetfelds erreicht werden, wodurch eine Magnetfeldverstärkung realisiert wird. Die Empfindlichkeit des Magnetometers kann dadurch um 40...60 dB gegenüber der Empfindlichkeit des einfachen Hall-Detektors gesteigert werden.

Prinzipiell lassen sich auf diese Weise Empfindlichkeiten und Auflösungen realisieren, die mit denen von SQUID-Magnetometern vergleichbar sind. Insbesondere lassen sich auf diese Weise Magnetometer in HTSL-Dünnfilmtechnologie realisieren, welche im Gegensatz zu HTSL-SQUID-Magnetometern, auch in größeren Stückzahlen und mit einer sehr guten Parameterkonstanz hergestellt werden können. Da der Detektor in weiten Bereichen linear ausgesteuert werden kann, ist eine Rückkopplung auf diesen nicht erforderlich. Durch die niedrige Induktivität des Einkoppelsystems läßt sich der Sensor zur Detektion von Magnetfeldern im Frequenzbereich zwischen 0...100 MHz einsetzen. Zur Verbesserung des Signal/Rausch-Abstands lassen sich die bei Hall-Sensoren üblichen AC-Detektionstechniken einsetzen.

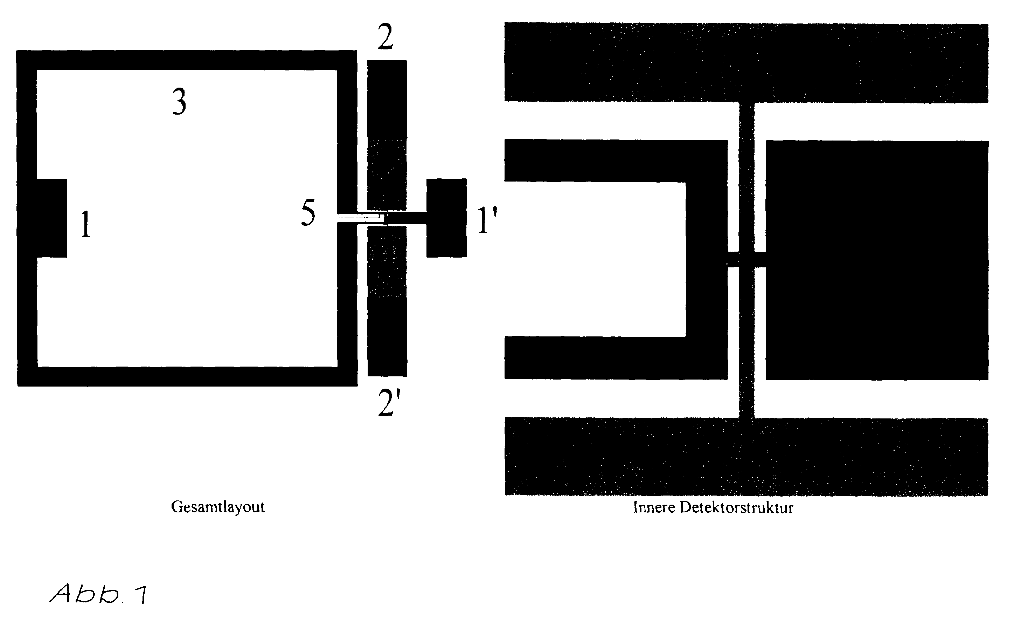

Als Ausführungsbeispiel ist in Abb. 1 das Layout eines erfindungsgemäß gestalteten Hall-Magnetometers mit supraleitenden Magnetfeldverstärker, einschließlich der inneren Detektrstruktur, dargestellt. Als Magnetfeldverstärker dient dabei eine supraleitende Ringstruktur 3, die nahe am Hall-Detektor 4 zu einer Einkoppelleitung 5 verengt ist. Der Hall-Detektor 4 wird in üblicher Weise mit einem hochkonstanten Querstrom, der über die Punkte 1 und 1' eingespeist wird, betrieben. Die Ausgangsspannung wird senkrecht zur Richtung des Querstroms an den Punkten 2 und 2' abgegriffen.

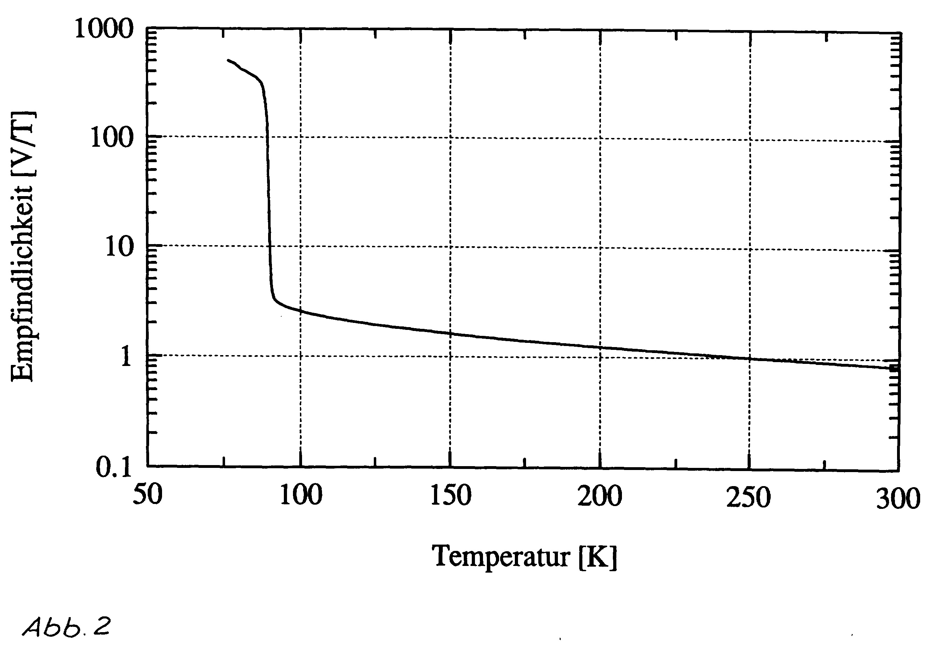

In Abb. 2 ist die Temperaturabhängigkeit der Magnetfeldempfindlichkeit eines Hall-Magnetometer mit supraleitenden Magnetfeldverstärker dargestellt. Durch das Wirken des supraleitenden Magnetfeldverstärkers steigt die Empfindlichkeit bei 89 K etwa um den Faktor 100 an. Bei 77 K steigt die Empfindlichkeit auf etwa das 550-fache gegenüber der bei Zimmertemperatur an.

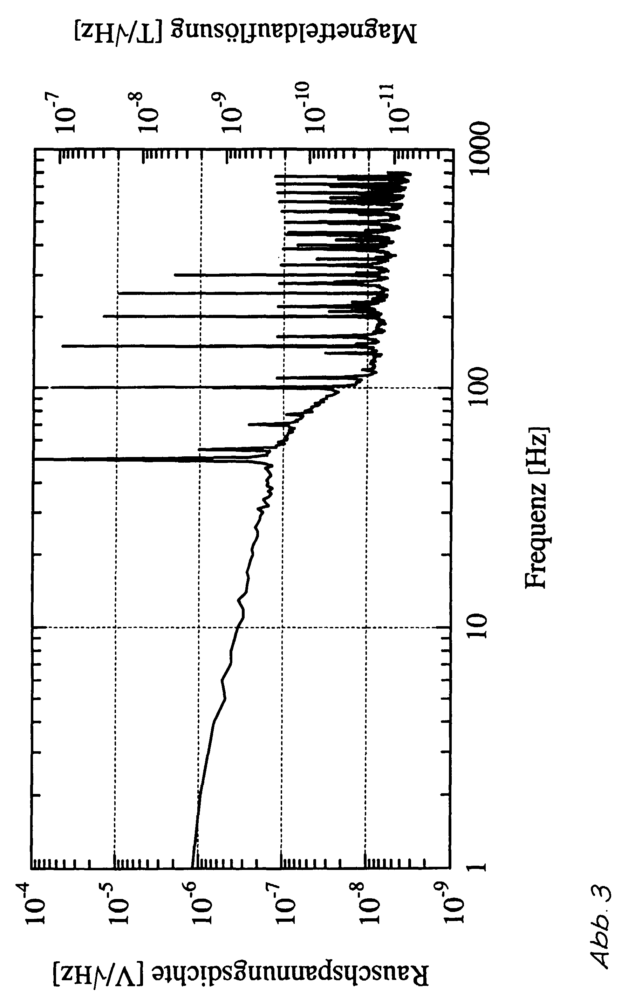

In Abb. 3 ist das Rauschspektrum eines Hall-Magnetometers mit supraleitenden Magnetfeldverstärker im Frequenzbereich zwischen 1...800 Hz dargestellt.

## Patentansprüche

1. Magnetometer in Dünnfilmtechnologie, dadurch gekennzeichnet, daß ein Hall-Detektor (4) mit einem supraleitenden Magnetfeldverstärker mit einer Ringstruktur (3), die nahe am Hall-Detektor (4) zu einer Einkoppelleitung (5) verengt ist, kombiniert ist.

2. Magnetometer nach Anspruch 1, dadurch gekennzeichnet, daß die Realisierung des Magnetfeldverstärkers mit konventionellen und Hochtemperatursupraleitern erfolgt.
